# DEMANDE DE BREVET EUROPEEN

(11) **EP 0 815 936 A2**
(43) Date de publication de la demande: **07.01.1998**
(21) Numéro de dépôt: 97401384.9
(22) Date de dépôt: 17.06.1997
(51) Int. Cl.: B01J 19/08, H01J 37/32

(54) **Dispositif d'excitation de gaz**

(30) Priorité: 02.07.1996 FR 9608229
(71) Demandeur: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: Sindzingre, Thierry, 94230 Cachan (FR); Rabia, Stéphane, du Général Leclerc, 91190 Gif Sur Yvette (FR)
(74) Mandataire: Vesin, Jacques

(57) **Abrégé**

Ce dispositif d'excitation, notamment de gaz pour traitement de surface, comporte une chambre (20) d'excitation de gaz munie d'un passage d'entrée (28) de gaz en communication avec une source primaire (36) d'alimentation en gaz et un passage de sortie (30) de gaz excité. Il comporte un étranglement (34) à effet Venturi disposé sur le trajet du gaz entre la source primaire (36) d'alimentation en gaz et ledit passage d'entrée (28). Il comporte en outre au moins une source secondaire (32) d'alimentation en gaz en communication avec une zone située en aval de l'étranglement (34), le gaz délivré par ladite source secondaire (32) étant entraîné par effet Venturi dans la chambre d'excitation (20).

## Description

La présente invention concerne un dispositif d'excitation de gaz en vue de la formation de molécules gazeuses excitées ou instables, en particulier adapté à l'excitation de gaz utilisés dans le domaine du traitement de surface, ou encore au traitement (dépollution) d'effluents gazeux.

On connaît, dans l'état de la technique, des dispositifs d'excitation de gaz, du type comprenant une chambre d'excitation de gaz munie d'un passage d'entrée de gaz en communication avec une source primaire d'alimentation en gaz et d'un passage de sortie de gaz excité.

Ce type de dispositif d'excitation permet de transférer de l'énergie chimique et thermique à un gaz à partir d'une énergie électrique, tout en opérant à une température proche de la température ambiante.

En fonctionnement, ce dispositif nécessite une consommation de gaz importante pour assurer un transport rapide d'espèces chimiquement activées jusqu'à une zone d'utilisation (minimiser le temps de « vol » entre l'entrée de gaz dans le dispositif et l'arrivée des espèces excitées sur la surface à traiter quand on considère l'exemple d'un traitement de surface).

Une telle consommation de gaz affecte de façon considérable l'intérêt économique d'un tel dispositif. On conçoit en effet par exemple les difficultés d'adaptation de tels procédés au traitement de pièces en grande production, comme c'est le cas de l'industrie automobile ou encore de verrerie, où le surcoût de la consommation de gaz n'est pas toujours tolérable.

Le but de l'invention est de pallier cet inconvénient et de fournir un dispositif d'excitation de gaz présentant une faible consommation en gaz et permettant en outre l'aspiration d'un mélange gazeux d'addition en amont de la chambre d'excitation de gaz.

Elle a donc pour objet un dispositif d'excitation de gaz du type précité, caractérisé en ce qu'il comporte un étranglement à effet Venturi disposé sur le trajet du gaz entre la source primaire d'alimentation et le passage d'entrée et en ce qu'il comporte en outre au moins une source secondaire d'alimentation en gaz en communication avec une zone située en aval dudit étranglement, le gaz délivré par ladite source secondaire étant entraîné par effet Venturi dans ladite chambre d'excitation sous l'action du gaz délivré par la source primaire.

On conçoit qu'un tel dispositif permet notamment d'appréhender les situations suivantes :
- le traitement de surface d'objets dans des conditions économiques de consommation de gaz : on peut pour cela envisager d'utiliser, à titre de source de gaz secondaire le gaz de traitement excité utilisé pour réaliser le traitement de surface (le gaz secondaire résultant de la transformation du gaz primaire à l'intérieur du dispositif d'excitation que l'on peut ainsi recycler au niveau du passage d'entrée);
- le traitement (dépollution) d'effluents gazeux : la source de gaz secondaire pouvant alors être constituée par l'effluent, entraîné par le gaz primaire dans la chambre d'excitation en vu de son retraitement, pour être ensuite évacué du dispositif par le passage de sortie de gaz afin d'être réutilisé ou encore évacué vers l'extérieur.

Les effluents gazeux ainsi retraités pourront selon l'invention provenir d'opérations très variées, qui produisent de tels effluents.

A titre illustratif, mais nullement limitatif, on peut citer le cas de fours de brasage de métaux, ou encore de fours réalisant des opérations de traitement thermique de métaux ou de céramiques, ou encore des fours continus réalisant des opérations dites de « brasage par refusion » qui sont des opérations de brasage de composants sur circuits électroniques utilisant une pâte à braser dont la formulation comporte outre l'alliage métallique réalisant le joint de soudure des solvants et autres flux chimiques plus ou moins résineux facilitant le mouillage. La montée en température occasionne alors, dans l'atmosphère à l'intérieur du four, des dégagements importants, notamment de solvants et autres composants organiques qu'il est avantageux de pouvoir éliminer, que ce soit avant de rejeter l'atmosphère vers l'extérieur ou bien afin de la recycler pour la réutiliser.

L'invention peut en outre comporter une ou plusieurs caractéristiques suivantes :
- le dispositif d'excitation comporte un canal de recirculation de gaz reliant un volume clos situé en aval de la chambre d'excitation et ladite zone disposée en aval de l'étranglement à effet Venturi, ladite source secondaire d'alimentation en gaz étant constituée par ledit volume clos;
- ladite source secondaire d'alimentation en gaz est constituée par une source d'alimentation en gaz d'addition reliée, par un canal d'aspiration de gaz, à ladite zone disposée en aval de l'étranglement à effet Venturi, ledit gaz d'addition étant destiné à être mélangé, en amont de la chambre d'excitation, au gaz délivré par ladite source primaire, par exemple pour former après excitation un gaz de traitement de surface, ou encore par exemple pour être dépollué (effluent) à l'intérieur du dispositif;
- la source primaire d'alimentation en gaz est constituée par une source d'alimentation en gaz inerte, ladite source secondaire étant constituée par une source d'alimentation en gaz actif ;
- le dispositif d'excitation comporte, connectées à une source de haute tension alternative à haute fréquence, une première électrode excitatrice interne de forme cylindrique et une seconde électrode excitatrice externe de forme cylindrique et munie de fentes longitudinales sensiblement opposées constituant lesdits passages d'entrée et de sortie de gaz, lesdites première et seconde électrodes excitatrices étant disposées de façon coaxiale et délimitant ladite chambre d'excitation de gaz, une couche d'un matériau diélectrique étant disposée sur la surface d'au moins une des électrodes en regard de l'autre électrode;
- le dispositif d'excitation comporte au moins une chambre d'homogénéisation disposée en sortie d'au moins une desdites sources primaire et secondaire en vue de la distribution uniforme du gaz fourni à ladite chambre d'excitation ;
- le dispositif d'excitation comporte une conduite d'amenée de gaz comprenant un premier cylindre interne muni d'une première extrémité raccordée à la source primaire d'alimentation en gaz et d'une extrémité opposée fermée et comportant une fente longitudinale, et un deuxième cylindre externe coaxial audit premier cylindre, muni de zones d'extrémité opposées fermées et comportant une fente longitudinale distributrice de gaz en communication avec ledit passage d'entrée de gaz et s'étendant à l'opposé de la fente ménagée dans ledit premier cylindre, en vue de la distribution uniforme du gaz fourni à ladite chambre d'excitation.

D'autres caractéristiques et avantages de l'invention ressortiront de la description suivante, donnée uniquement à titre d'exemple et faite en référence aux dessins annexés sur lesquels :
- la figure 1 est une vue schématique en coupe transversale d'un dispositif d'excitation selon l'invention;
- la figure 2 est une courbe du débit de gaz mesuré en sortie de la chambre d'excitation en fonction du débit de gaz délivré par la source primaire d'alimentation; et
- la figure 3 est une vue schématique en coupe transversale d'un dispositif d'excitation selon un autre mode de réalisation.

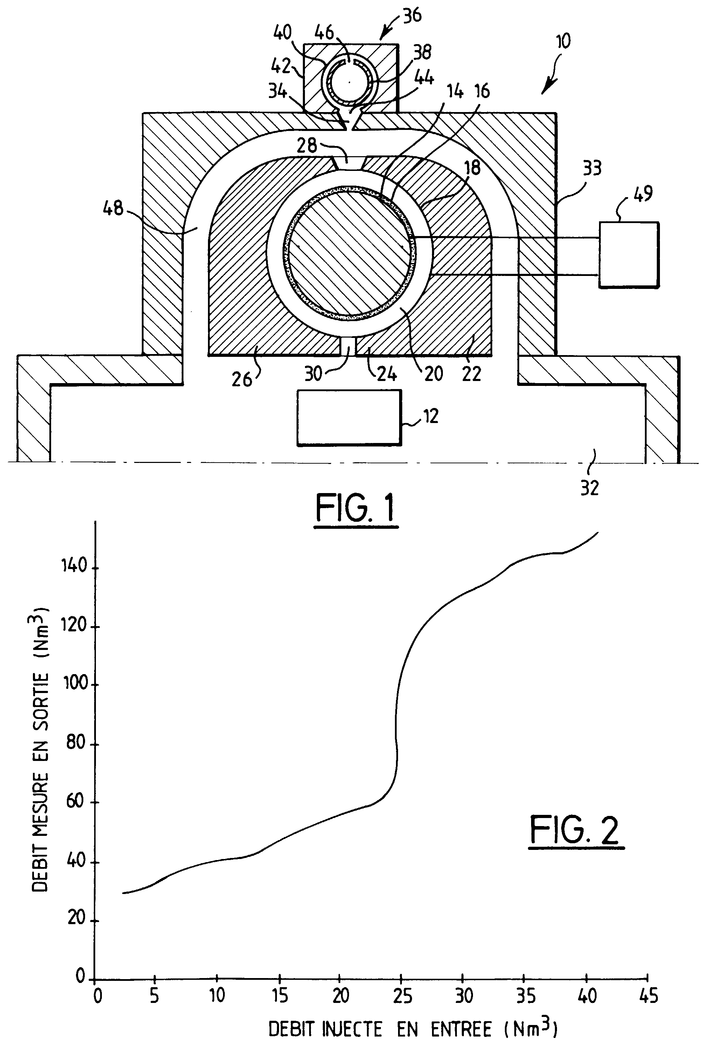

Sur la figure 1, on a représenté un dispositif d'excitation selon l'invention, désigné par la référence numérique générale 10.

Le mode de réalisation exemplifié ici peut par exemple être destiné à l'excitation d'un gaz fourni par une source primaire d'alimentation en gaz en vue d'effectuer un traitement de surface d'une pièce 12.

On voit sur cette figure 1 que le dispositif d'excitation comporte une première électrode excitatrice interne 14 de forme cylindrique revêtue extérieurement d'une couche 16 de matériau diélectrique et disposée à l'intérieur d'une seconde électrode excitatrice externe, également de forme cylindrique 18. Les deux électrodes excitatrices 14 et 18 sont disposées de façon coaxiale et délimitent entre elles une chambre 20 d'excitation de gaz.

La seconde électrode externe 18 est formée par la face interne d'un bloc métallique 22 longitudinal constitué par l'association de deux parties 24 et 26 complémentaires disposées en regard et espacées l'une de l'autre.

Les deux parties 24 et 26 sont séparées l'une de l'autre par deux passages 28 et 30, constituant respectivement un passage d'entrée de gaz 28 dans la chambre 20 d'excitation et un passage de sortie de gaz 30 en communication avec un espace clos 32 dans lequel est placée la pièce 12 à traiter.

On note également sur la figure 1 que le bloc métallique 22 est disposé dans une cage 33 munie d'une fente longitudinale 34 disposée en regard du passage d'entrée 28 de la chambre d'excitation 20 et en communication avec une conduite 36 d'amenée de gaz reliée à la source d'alimentation en gaz primaire.

La largeur de l'étranglement 34 (ici représenté sous la forme d'une fente) est avantageusement sensiblement inférieure à celle du passage d'entrée 28. Un ratio entre les deux largeurs compris entre 1 et 3 sera préférentiellement utilisé.

La conduite d'amenée de gaz 36 comporte un premier cylindre interne 38 coaxial au reste du dispositif et disposé à l'intérieur d'un second cylindre 40 constitué par la paroi interne cylindrique d'un carter 42.

Le carter 42 est muni d'une fente longitudinale 44 s'étendant parallèlement à l'axe du premier cylindre 38 et en communication avec la fente longitudinale 34 de la cage 33.

Par ailleurs, le premier cylindre est muni d'une ouverture 46 parallèle à l'ouverture 44 et disposée à l'opposé de celle-ci.

Le premier cylindre 38 comporte une première extrémité, située en arrière du plan de la figure 1, en communication avec la source d'alimentation en gaz et une extrémité opposée, située en avant du plan de la figure 1, fermée.

Par ailleurs, les deux extrémités opposées du cylindre 40 sont fermées.

De surcroît, l'étranglement 34 de la cage 33 a ici une forme sensiblement de profile en V provoquant de façon connue une augmentation de la vitesse du gaz délivré par la source d'alimentation en gaz à la chambre d'excitation 20 ainsi qu'un abaissement correspondant de la pression de ce gaz (essentiellement au voisinage du passage 28).

La cage 33 et le bloc métallique 22 sont espacés et délimitent un canal 48 d'aspiration de gaz s'étendant entre le passage d'entrée de gaz 28, en aval de l'étranglement à effet Venturi 34, et le volume clos 32.

On voit enfin sur la figure 1 que le dispositif est complété par une source 49 de haute tension alternative à haute fréquence connectée à l'électrode d'excitation interne 14 et à l'électrode d'excitation externe 18, en vue de leur polarisation.

On conçoit que si l'invention a été dans ce qui précède tout particulièrement illustrée à l'aide d'étranglements à effet Venturi se présentant sous la forme de fentes, d'autres configurations peuvent être envisagées sans sortir nullement du cadre de l'invention, telles que par exemple une rangée d'orifices régulièrement espacés ou non, ou encore à espacement déterminé et contrôlé.

Le fonctionnement du dispositif de la figure 1 est le suivant.

Le gaz délivré par la source d'alimentation est fourni à une pression de l'ordre de quelques bars. Il circule dans le premier cylindre 38 de la conduite d'amenée de gaz 36. Il chemine ensuite à travers l'orifice 46 puis entre l'espace délimité par le premier cylindre 38 et le deuxième cylindre 40, puis dans la fente 34. Au cours de ce cheminement, le gaz subit durant le trajet une perte de charge relativement importante adaptée pour conférer à ce gaz une distribution de vitesse et de pression homogène le long de la conduite d'amenée de gaz 36, et donc le long de la fente 34.

Le gaz circule alors, à travers la fente 34 et le passage 28, dans la chambre d'excitation 20, dans laquelle il subit une excitation de façon connue sous l'action des électrodes 16 et 18 alimentées par la source de tension alternative à haute fréquence 49.

Le gaz ainsi excité s'échappe par la suite à travers le passage de sortie 30 en vue par exemple du traitement d'une pièce 12.

Comme cela a été mentionné précédemment, le gaz subit, sous l'action de l'étranglement 34 à effet Venturi, un abaissement de pression, en aval de cet étranglement.

Cet abaissement de pression provoque une aspiration, par effet Venturi, du gaz présent dans le canal d'aspiration 48, et donc du gaz présent dans le volume clos 32.

On conçoit donc que le gaz, après traitement de la pièce 12, subit une recirculation et est réinjecté dans la chambre d'excitation 20 en vue de sa reexcitation.

Le dispositif qui vient d'être décrit permet donc une économie considérable en gaz de traitement puisque le gaz désexcité présent dans le volume clos 32 constitue une source secondaire d'alimentation dont le gaz qu'il fournit est mélangé au gaz fourni par la source primaire d'alimentation en gaz.

On voit sur la figure 2, sur laquelle on a représenté une courbe du débit délivré en sortie du passage de sortie de gaz 30 en fonction du débit injecté par la conduite d'amenée de gaz 36 que le dispositif qui vient d'être décrit permet une économie considérable de gaz puisque pour obtenir par exemple un débit de gaz voisin de 30 Nm³/h en sortie il ne faut injecter que 3 à 5 Nm³/h de gaz en entrée.

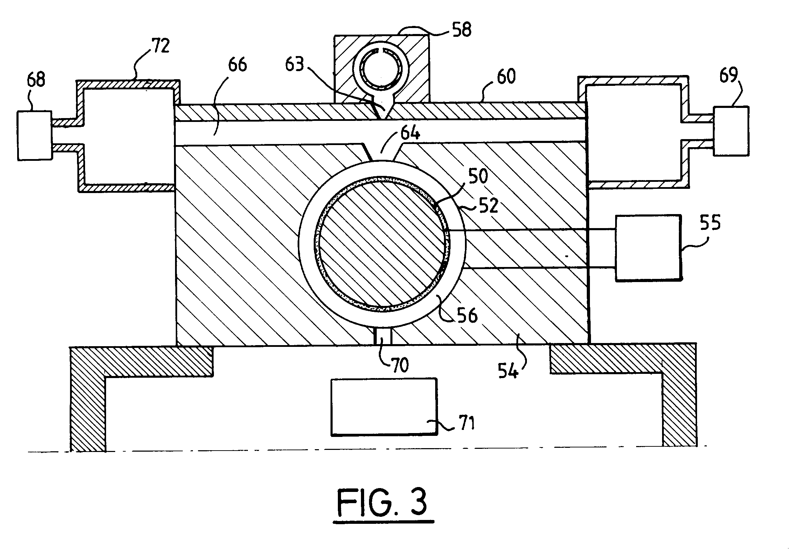

On a représenté sur la figure 3 un dispositif d'excitation de gaz selon un autre mode de réalisation.

Comme dans l'exemple de réalisation précédent, décrit en référence à la figure 1, ce dispositif d'excitation comporte une électrode d'excitation primaire 50 coaxiale à une électrode d'excitation secondaire 52 formée par la paroi interne d'un bloc métallique 54 en deux parties et délimitant une chambre d'excitation 56 en communication avec une source primaire d'alimentation en gaz par l'intermédiaire d'une conduite d'amenée de gaz 58.

Comme précédemment, les électrodes primaire 50 et secondaire 52 sont connectées à une source 55 de haute tension alternative à haute fréquence en vue de leur excitation.

On voit sur cette figure 3, que le dispositif comporte en outre une plaque 60 superposée au bloc métallique 54 et espacée de celui-ci ainsi qu'aux deux électrodes d'excitation 50 et 52.

La plaque 60 est constituée par l'association de deux plaques côte à côte et délimitant une fente 63 formant un étranglement en V à effet Venturi en communication avec un passage 64 d'entrée de gaz dans la chambre d'excitation 56.

L'espace délimité par la plaque 60 et le bloc métallique 54 constitue une conduite d'aspiration de gaz 66 en communication avec deux sources secondaires d'alimentation en gaz 68 et 69 disposées de part et d'autre du bloc métallique 54 et délivrant un gaz ou un mélange gazeux d'addition destiné par exemple à être mélangé au gaz délivré par la source primaire, en vue de son excitation pour un traitement de surface ultérieur.

Comme dans l'exemple de réalisation décrit en référence à la figure 1, le gaz délivré par les sources secondaires d'alimentation 68 et 69 est aspiré, par effet Venturi, dans la zone située en aval de l'étranglement 63 et entraîné dans la chambre d'excitation 56 et s'échappe à travers un passage de sortie de gaz excité 70 vers une pièce à traiter 71.

On conçoit donc que selon ce mode de réalisation il est par exemple possible de mélanger plusieurs gaz de traitement, pour créer des espèces chimiques excitées de gaz différents en vue d'effectuer un traitement de surface de la pièce 71. On pourra donc envisager, tant pour la source primaire que pour la source d'addition, un gaz comportant au moins un membre des groupes formés par les gaz inertes, les gaz oxydants, les gaz réducteurs.

Bien entendu, il est possible de doter le dispositif qui vient d'être décrit en référence à la figure 3 d'un canal de recirculation de gaz, comme dans l'exemple de réalisation de la figure 1.

Il est à noter que, de préférence, chaque source secondaire d'alimentation en gaz 68 et 69 est associée à une chambre d'homogénéisation 72 en vue de permettre, de façon classique, une distribution uniforme du gaz, en vitesse et en pression, dans la conduite 66 en vue de son entraînement dans la chambre d'excitation 56.

Bien entendu, si le mode de réalisation exemplifié figure 3 comporte deux sources secondaires d'addition 68 et 69, il est parfaitement concevable de n'en disposer qu'une seule, sans pour cela sortir du cadre de la présente invention.

De même, si en liaison avec cette figure 3 on a tout particulièrement évoqué l'application « traitement de surface d'objets », on conçoit que l'on peut utiliser l'installation de la figure 3 ou une installation très proche (à une ou plusieurs sources secondaires) pour le traitement/dépollution d'effluents gazeux par exemple dans le cadre suivant :
- la source secondaire est constituée d'effluents à traiter (en provenance d'une opération quelconque);
- les effluents sont entraînés à l'intérieur de la décharge en vue de leur retraitement, sous l'action du gaz primaire qui peut être par exemple un gaz inerte ou encore un gaz plus actif tel qu'un gaz réducteur;
- les effluents une fois traités par la décharge obtenus en sortie de gaz 70 sont alors par exemple réutilisés pour une opération du genre de celle qui les avait émis en amont, ou encore éliminés vers l'atmosphère environnante.

## Revendications

1. Dispositif d'excitation de gaz, comprenant une chambre (20;56) d'excitation de gaz munie d'un passage d'entrée (28;64) de gaz en communication avec une source primaire (36;58) d'alimentation en gaz et un passage de sortie de gaz excité (30;70), caractérisé en ce qu'il comporte un étranglement (34;63) à effet Venturi disposé sur le trajet du gaz entre la source primaire (36;58) d'alimentation et ledit passage d'entrée (28;64) et en ce qu'il comporte en outre au moins une source secondaire (32;68;69) d'alimentation en gaz en communication avec une zone située en aval dudit étranglement (34;63), le- gaz délivré par ladite source secondaire (32;68,69) étant entraîné par effet Venturi dans ladite chambre d'excitation (20;56) sous l'action du gaz délivré par la source primaire.

2. Dispositif selon la revendication 1, caractérisé en ce qu'il comporte un canal (48) de recirculation de gaz reliant un volume clos (32) situé en aval de la chambre (20) d'excitation et ladite zone disposée en aval de l'étranglement (34) à effet Venturi, ladite source secondaire d'alimentation en gaz étant constituée par ledit volume clos (32).

3. Dispositif selon la revendication 2, caractérisé en ce que le dit volume clos est constitué par un espace intérieur délimité par une enceinte, en communication avec ledit passage de sortie de gaz excité, au sein de laquelle on pratique un traitement de surface d'objets à l'aide du dit gaz excité.

4. Dispositif selon la revendication 1, caractérisé en ce que ladite source secondaire d'alimentation en gaz est constituée par une source (68,69) d'alimentation en gaz d'addition reliée, par un canal (66) d'aspiration de gaz, à ladite zone disposée en aval de l'étranglement (34;63) à effet Venturi, ledit gaz d'addition étant destiné à être mélangé, en amont de la chambre (20;56) d'excitation, au gaz délivré par ladite source primaire.

5. Dispositif selon la revendication 4, caractérisé en ce que la dite source de gaz secondaire d'addition est constituée par un effluent gazeux devant subir un traitement de dépollution à l'intérieur de la chambre.

6. Dispositif d'excitation selon l'une quelconque des revendications 1 à 5, caractérisé en ce que la source primaire (36;58) d'alimentation en gaz est constituée par une source d'alimentation en gaz inerte, ladite source secondaire (32;68,69) étant constituée par une source d'alimentation en gaz actif.

7. Dispositif d'excitation selon l'une quelconque des revendications 1 à 6, caractérisé en ce qu'il comporte, connectées à une source (49;55) de haute tension alternative à haute fréquence, une première électrode excitatrice (14;50) interne de forme cylindrique et une seconde électrode excitatrice (18;52) externe de forme cylindrique et munie de fentes (28,30;64,70) longitudinales sensiblement opposées constituant lesdits passages d'entrée et de sortie de gaz, lesdites première (14;50) et seconde (18;52) électrodes excitatrices étant disposées de façon coaxiale et délimitant ladite chambre (20;56) d'excitation de gaz, une couche d'un matériau diélectrique étant disposée sur la surface d'au moins une des deux électrodes en regard de l'autre électrode.

8. Dispositif d'excitation selon l'une des revendications précédentes, caractérisé en ce qu'il comporte au moins une chambre d'homogénéisation (72) disposée en sortie d'au moins une desdites sources primaire (58) et secondaire (68,69) en vue de la distribution uniforme du gaz fourni à ladite chambre (56) d'excitation.

9. Dispositif selon l'une quelconque des revendications 1 à 7, caractérisé en ce qu'il comporte une conduite d'amenée de gaz comprenant un premier cylindre (38) interne muni d'une première extrémité raccordée à la source primaire d'alimentation en gaz et d'une extrémité opposée fermée et comportant une fente (46) longitudinale, et un deuxième cylindre (40) externe coaxial audit premier cylindre, muni de zones d'extrémité opposées fermées et comportant une fente (44) longitudinale distributrice de gaz en communication avec ledit passage (28) d'entrée de gaz et s'étendant à l'opposé de la fente (46) ménagée dans ledit premier cylindre (38), en vue de la distribution uniforme du gaz fourni à ladite chambre (20) d'excitation.

10. Dispositif selon l'un des revendications précédentes, caractérisé en ce que ledit étranglement à la forme d'une fente sensiblement longitudinale dont la largeur est sensiblement inférieure à celle dudit passage d'entrée (28).

11. Dispositif selon l'une des revendications précédentes, caractérisé en ce que la source primaire de gaz est à une pression supérieure ou égale à 3 bars.

12. Dispositif selon l'une quelconque des revendications 1 à 11, caractérisé en ce que le gaz fourni par lesdites sources primaire (36;58) et secondaire (32;68,69) d'alimentation en gaz comporte au moins un gaz choisi parmi les gaz inertes, les gaz oxydants, et les gaz réducteurs.
